# EUROPÄISCHE PATENTSCHRIFT

(11) **EP 2 790 479 B1**
(45) Veröffentlichungstag und Bekanntmachung des Hinweises auf die Patenterteilung: **12.10.2016**
(21) Anmeldenummer: 13163468.5
(22) Anmeldetag: 12.04.2013
(51) Int. Cl.: H05K 7/20, G06F 1/20, H05K 7/14

(54) **Gehäuse zur Aufnahme von elektronischen Steckkarten**
Housing for installing electronic plug-in cards
Boîtier destiné à la réception de cartes enfichables électroniques

(43) Veröffentlichungstag der Anmeldung: 15.10.2014
(73) Patentinhaber: Pentair Technical Solutions GmbH, 75334 Straubenhardt (DE)
(72) Erfinder: Mann, Dietmar, 75196 Remchingen (DE); Kistner, Oliver, 75177 Pforzheim (DE)
(74) Vertreter: Durm & Partner

(56) Entgegenhaltungen:
- US-A1- 2005 128 704
- US-B1- 7 256 992
- US-B1- 8 208 253
- Eike Waltz: "AdvancedTCA Extensions PICMG 3.7 Mechanical", Proceedings, ATCA Summit 2012,, 18. September 2012 (2012-09-18), XP055082659, Gefunden im Internet: URL:http://www.advancedtcasummit.com/Engli sh/Collaterals/Proceedings/2012/20120918_S A101_102_Waltz.pdf [gefunden am 2013-10-04]

## Beschreibung

Die Erfindung betrifft ein Gehäuse zur Aufnahme von elektronischen Steckkarten, mit einem frontseitigen Kartenkorb, einem rückseitigen Kartenkorb, zumindest einer vertikalen Backplane, die zwischen dem frontseitigen Kartenkorb und dem rückseitigen Kartenkorb angeordnet ist, einem unter dem frontseitigen Kartenkorb vorgesehenen Einbauraum, in den wenigstens ein Lüftereinschub von der Frontseite her horizontal einschiebbar ist, und einem Stromeinspeisemodul mit einer Elektronikeinheit, welche die Backplane mit Strom versorgt.

Ein derartiges Gehäuse kommt beispielsweise bei modularen Computersystemen für die Telekommunikationsindustrie zum Einsatz. Dabei ist der rückseitige Kartenkorb deutlich kürzer ausgebildet als der frontseitige Kartenkorb. Die einzelnen Steckkarten werden in die zwischen den beiden Kartenkörben angeordnete Backplane eingesteckt. Das Gehäuse umschließt den frontseitigen und den rückseitigen Kartenkorb sowie den darunter liegenden Einbauraum für Lüfter.

Aufgrund der unterschiedlichen Größen der Kartenkörbe können im rückseitigen Kartenkorb im Vergleich zum frontseitigen Kartenkorb nur deutlich kürzere Steckkarten aufgenommen werden. Dementsprechend ist auch der Leistungsbedarf der kleineren Steckkarten geringer als der Leistungsbedarf der größeren Steckkarten.

Die Stromversorgung der Backplanes und der damit verbundenen Steckkarten erfolgt durch ein spezielles Stromeinspeisemodul. Dieses ist mit der Haupt-Backplane verbunden und befindet sich üblicherweise unterhalb des rückseitigen Kartenkorbs. Es nimmt oft den gesamten oder jedenfalls einen großen Teil des Raums unterhalb des rückseiteigen Kartenkorbs ein.

Um die Steckkarten während des Betriebs zu kühlen, sind elektrische Lüfter unterhalb oder oberhalb des frontseitigen Kartenkorbs angeordnet. Diese erzeugen einen Luftstrom, der die frontseitigen Steckkarten umströmt. Um auch die Steckkarten im rückseitigen Kartenkorb zu kühlen, werden oftmals Öffnungen in der Backplane vorgesehen. Durch diese Öffnungen strömt die Kühlluft an dem Stromeinspeisemodul vorbei in den hinteren Kartenkorb. Der die Steckkarten im rückseitigen Kartenkorb erreichende Luftstrom ist deshalb deutlich geringer als im frontseitigen Korb.

Gehäuse mit front- und rückseitigen luftgekühlten Steckkarten werden beispielsweise in den Dokumenten US 8 208 253 B1, US 2005/128704 A1 und US 7 256 992 B1 offenbart.

Neue Normen modularer Computersysteme, zum Beispiel AdvancedTCA Extensions, definieren ein modulares Aufbausystem mit einem Gehäuse, dessen rückseitiger Kartenkorb die gleiche Größe aufweist wie der frontseitige Kartenkorb. Die bisher nur im frontseitigen Kartenkorb verbauten Steckkarten sollen in identischer Größe auch im rückseitigen Kartenkorb zum Einsatz kommen. Dadurch erhöht sich der Leistungsbedarf der rückseitigen Steckkarten auf bis zu 500 Watt. Entsprechend steigt der Kühlbedarf der hinteren Steckkarten. Die notwendige Kühlung des rückseitigen Kartenkorbs kann durch das bestehende Kühlkonzept nicht mehr gewährleistet werden.

Angesichts der beschriebenen Problematik ist es Aufgabe der vorliegenden Erfindung, ein verbessertes Gehäuse bereitzustellen, das die Anforderung der neuen Norm erfüllt und eine ausreichende Kühlung der Steckkarten beider Kartenkörbe ermöglicht.

Gelöst wird die vorliegende Aufgabe durch ein Gehäuse zur Aufnahme von elektronischen Steckkarten mit den Merkmalen des Anspruchs 1.

Erfindungsgemäß erstreckt sich der Einbauraum für den Lüftereinschub durchgehend bis in den Bereich des rückseitigen Kartenkorbs, wobei der Einbauraum wahlweise unter oder über den Kartenkörben angeordnet sein kann. Dadurch wird es möglich, einen Lüftereinschub frontseitig so in das Gehäuse einzuschieben, dass er sich sowohl unter bzw. über dem frontseitigen wie auch unter bzw. über dem rückseitigen Kartenkorb erstreckt. Die elektrischen Lüfter des Lüftereinschubs können entweder Luft aus der Umgebung ansaugen und durch die Kartenkörbe drücken ("push") oder die erwärmte Abluft aus den Kartenkörben absaugen ("pull").

Die Elektronikeinheit des Stromeinspeisemoduls ist unterhalb oder oberhalb des rückseitigen Kartenkorbs im Bereich der Rückseite des Gehäuses angeordnet und begrenzt den Einbauraum nach hinten. Die Elektronikeinheit wird bevorzugt von der Rückseite in das Gehäuse eingeschoben und ist auch nur von der Rückseite des Gehäuses aus zugänglich. Die Elektronikeinheit kann dadurch in üblicher Weise mit Netzspannung versorgt werden. Im Falle eines Defekts ist es möglich, die Elektronikeinheit einfach und schnell auszutauschen.

Die Elektronikeinheit ist durch eine Anzahl starrer elektrischer Leiter mit der Backplane verbunden, wobei die Leiter parallel und mit Abstand zueinander horizontal zwischen dem rückseitigen Kartenkorb und dem Einbauraum für den Lüftereinschub verlaufen. In dem Einbauraum sitzt auch der Lüftereinschub, der einen Kühlluftstrom zum Kühlen der Steckkarten im rückseitigen Kartenkorb erzeugt. Die Kühlluft strömt durch Freiräume zwischen den elektrischen Leitern zu den Steckkarten im rückseitigen Kartenkorb. Die parallel und voneinander beabstandet angeordneten elektrischen Leiter des Stromeinspeisemoduls haben nur einen sehr geringen Strömungswiderstand. Die Kühlluft kann deshalb nahezu ungehindert in den rückseitigen Kartenkorb strömen bzw., im Falle saugender Lüfter, aus dem Kartenkorb in den Einbauraum strömen.

Vorzugsweise umfassen die elektrischen Leiter eine Anzahl von Stromschienen, welche jeweils einen rechteckigen Querschnitt aufweisen. Mithilfe solcher Stromschienen ist es möglich, die Backplane mit sehr hohen Stromstärken zu versorgen. Der rechteckige Querschnitt der Stromschienen weist jeweils zwei einander gegenüberliegende lange Seiten und zwei kurze Seiten auf. Indem die langen Seiten des Querschnitts im Wesentlichen vertikal verlaufen, wird der Strömungswiderstand der Stromschienen gering gehalten. Die elektrischen Leiter können auch weitere Leiter, wie beispielsweise Signalleiter, umfassen. Bevorzugt sind die Signalleiter als dünne Leiterplatten oder Flachbandleitungen ausgebildet, die gleichfalls vertikal ausgerichtet sind, um die Kühlluftströmung möglichst wenig zu behindern.

Ein weiteres optionales Merkmal der Erfindung ist, dass die langen Seiten der Stromschienen Luftleitflächen für Kühlluft bilden. Somit kann die an den Stromschienen vorbeiströmende Kühlluft mithilfe der Luftleitflächen gezielt geführt werden. Luftturbulenzen können dadurch verringert werden, so dass eine gleichmäßige Kühlluftströmung an den Steckkarten vorbeiströmt. Dadurch wird die Kühlung der Steckkarten nochmals verbessert.

Es ist zweckmäßig, das Stromeinspeisemodul im Querschnitt L-förmig auszubilden, wobei die Elektronikeinheit den kurzen L-Schenkel und die Stromschienen den langen L-Schenkel bildet. Durch den L-förmigen Querschnitt ist es möglich, die kompakte Elektronikeinheit an der Rückseite des Gehäuses anzuordnen, während die schmalen Stromschienen zwischen dem rückseitigen Kartenkorb und dem Einbauraum für den Lüftereinschub horizontal verlaufen. Die Stromschienen überbrücken den Abstand zwischen der Elektronikeinheit und der Backplane.

Bevorzugt sind die Stromschienen von einem rechteckigen U-förmigen Rahmen umgeben, wobei die U-Schenkel parallel zu den Stromschienen verlaufen und der U-Rücken dazu quer und parallel zur Backplane. Beispielsweise umfasst der U-förmige Rahmen zwei zueinander parallel angeordnete U-Schenkel, die über einen U-Rücken miteinander verbunden sind. Der U-Rücken verläuft quer zu den beiden U-Schenkeln. Mithilfe des U-förmigen Rahmens werden die Stromschienen mechanisch stabilisiert. Beispielsweise ist der U-förmige Rahmen mit der Elektronikeinheit verbunden und die Stromschienen an dem U-förmigen Rahmen befestigt. Der U-förmige Rahmen, die Stromleiter und die Elektronikeinheit bilden eine stabile verwindungssteife Einheit. Eine eventuell auf das Stromeinspeisemodul wirkende Kraft wird primär von dem U-förmigen Rahmen aufgenommen, so dass die Stromschienen vor schädlichen Krafteinwirkungen geschützt sind. Insbesondere beim Einschieben des Stromeinspeisemoduls in das Gehäuse wird so eine Beschädigung der Stromschienen vermieden.

Es ist zweckmäßig, dass der den U-Rücken bildende Abschnitt des Rahmens Steckverbinder zur Herstellung der Verbindung mit der Backplane trägt. Bevorzugt sind diese Steckverbinder in Einschubrichtung des Stromeinspeisemoduls, entlang der das Stromeinspeisemodul in das Gehäuse eingeschoben wird, angeordnet. Dadurch ist es möglich, das Stromeinspeisemodul mit der Backplane auf einfache Art und Weise zu verbinden. Dazu wird es von der Rückseite des Gehäuses aus in Richtung der Backplane in das Gehäuse eingeschoben, wobei die Steckverbinder auf entsprechende Gegenstücke an der Backplane aufgeschoben werden.

In vorteilhafter Weise weist der Einbauraum zwei Einbauebenen vertikal übereinander auf, wobei die erste Einbauebene einen ersten Lüftereinschub aufnehmen kann, welcher sich bis in den Bereich des rückseitigen Kartenkorbs erstreckt, und die zweite Einbauebene einen zweiten Lüftereinschub aufnehmen kann, welcher sich nur bis zum Ende des frontseitigen Kartenkorbs erstreckt. Die zweite kürzere Einbauebene grenzt unmittelbar an den frontseitigen Kartenkorb an.

Bevorzugt sind in der ersten Einbauebene Lüfter angeordnet, die speziell die Steckkarten im rückseitigen Kartenkorb kühlen. In der zweiten Einbauebene können weitere Lüfter angeordnet sein, die vor allem die Steckkarten im frontseitigen Kartenkorb mit Kühlluft versorgen. Somit kann eine ausreichende und gleichmäßige Kühlung beider Kartenkörbe gewährleistet werden. Darüber hinaus kann die Kühlung der beiden Kartenkörbe unabhängig voneinander erfolgen. Die Lüftereinschübe für die erste und die zweite Einbauebene können getrennt oder als eine gemeinsame Baueinheit ausgeführt sein, welche frontseitig in den Einbauraum einschiebbar ist. Es versteht sich, dass der Einbauraum zweckmäßig mit seitlichen Schiebeführungen für die Lüftereinschübe ausgestattet ist.

Ein weiteres optionales Merkmal der Erfindung ist, dass die Backplane mit ihrem einen Ende ein Stück weit in den Einbauraum hineinragt und dadurch die benachbarte zweite Einbauebene nach hinten begrenzt. Beispielsweise kann durch den hineinragenden Abschnitt ein Anschlag für den Lüftereinschub in der zweiten Einbauebene realisiert werden. Es ist auch vorstellbar, an dem in den Einbauraum hineinragenden Abschnitt der Backplane die Stromanschlüsse vorzusehen, über welche die Lüftereinschübe mit Strom versorgt werden.

Besonders bevorzugt ist eine Ausführungsform, bei der die Backplane an ihrer Rückseite im Bereich ihres in den Einbauraum hineinragenden Endes spezielle Steckverbinder zum Anschluss des Stromeinspeisemoduls trägt. Bevorzugt verlaufen die elektrischen Leiter des Stromeinspeisemoduls dann unterhalb bzw. oberhalb des rückseitigen Kartenkorbs in Höhe der zweiten Einbauebene des Einbauraums. Ragt die Backplane derart mit den Steckverbindern ein Stück in den Einbauraum hinein, kann das Stromeinspeisemodul einfach durch horizontales Einschieben in das Gehäuse mit der Backplane verbunden werden. In diesem Fall sind die Steckverbinder an der Backplane in Einschubrichtung des Stromeinspeisemoduls korrespondierend zu den Steckverbindern am U-förmigen Rahmen des Stromeinspeisemoduls angeordnet.

Teil der vorliegenden Erfindung ist auch ein spezielles Stromeinspeisemodul zum Einbau in ein erfindungsgemäßes Gehäuse, umfassend eine Elektronikeinheit zur Erzeugung der Versorgungsspannungen für die Backplane und elektrische Leiter, welche die Elektronikeinheit mit der Backplane verbinden. Die elektrischen Leiter umfassen erfindungsgemäß Stromschienen, die einen rechteckigen Querschnitt mit jeweils gegenüberliegenden langen Seiten und kurzen Seiten aufweisen. Die Stromschienen sind entlang der langen Seiten im Wesentlichen parallel zueinander und voneinander beabstandet angeordnet. Die langen Seiten der Stromschienen bilden Luftleitflächen. Durch die parallel und voneinander beabstandeten Stromschienen werden größtmögliche Freiräume geschaffen, die von Kühlluft frei durchströmbar sind. Insbesondere bieten die Stromschienen mit ihren rechteckigen Querschnitten einen sehr geringen Luftwiderstand. Darüber hinaus kann die durch die Freiräume strömende Luft mithilfe der Luftleitflächen gezielt geführt werden, wodurch Turbulenzen in vorbeiströmenden Luftströmen reduziert werden können.

Das Stromeinspeisemodul ist im Querschnitt L-förmig ausgebildet, wobei die Elektronikeinheit den kurzen L-Schenkel und die Stromschienen den langen L-Schenkel bildet. Der L-förmige Querschnitt ermöglicht es, die Elektronikeinheit an der Rückseite des erfindungsgemäßen Gehäuses anzuordnen während die Stromschienen in Richtung der im Gehäuse mittig angeordneten Backplane verlaufen und die Elektronikeinheit mit der Backplane verbinden.

Ein weiteres optionales Merkmal der Erfindung ist, dass die Stromschienen von einem U-förmigen Rahmen umgeben sind, wobei die U-Schenkel parallel zu den Stromschienen verlaufen und der U-Rücken dazu quer angeordnet ist. Der U-förmige Rahmen ist mit der Elektronikeinheit verbunden; er versteift den Bereich des Stromeinspeisemoduls in dem sich die Stromschienen befinden. Über dem U-förmigen Rahmen kann mechanische Last übertragen und damit ein Einwirken von Kräften auf die Stromschienen, die zu einer Beschädigung der Stromschienen führen würden, vermieden werden. Beispielsweise sind die U-Schenkel mit der Elektronikeinheit direkt verbunden. Der U-Rücken befindet sich auf der der Elektronikeinheit abgewandten Seite des U-förmigen Rahmens.

Es ist zweckmäßig, dass der den U-Rücken bildende Abschnitt des Rahmens Steckverbinder zur Herstellung der elektrischen Verbindung mit einer Backplane trägt. Mithilfe der Steckverbinder ist es auf einfache Art und Weise möglich, das Stromeinspeisemodul mit der zugehörigen Backplane zu verbinden. Bevorzugt sind die Steckverbinder entlang der Längsrichtung der langen L-Schenkel, dass heißt in Einschubrichtung des Stromeinspeisemoduls in das Gehäuse, angeordnet.

Ein Ausführungsbeispiel der Erfindung wird nachstehend anhand der beigefügten Zeichnungen beschrieben. Es zeigen:
- Figur 1: ein Gehäuse mit einem Stromeinspeisemodul, in einem vereinfachten Vertikalschnitt;
- Figur 2: das Stromeinspeisemodul aus Figur 1 in einer perspektivischen Ansicht.

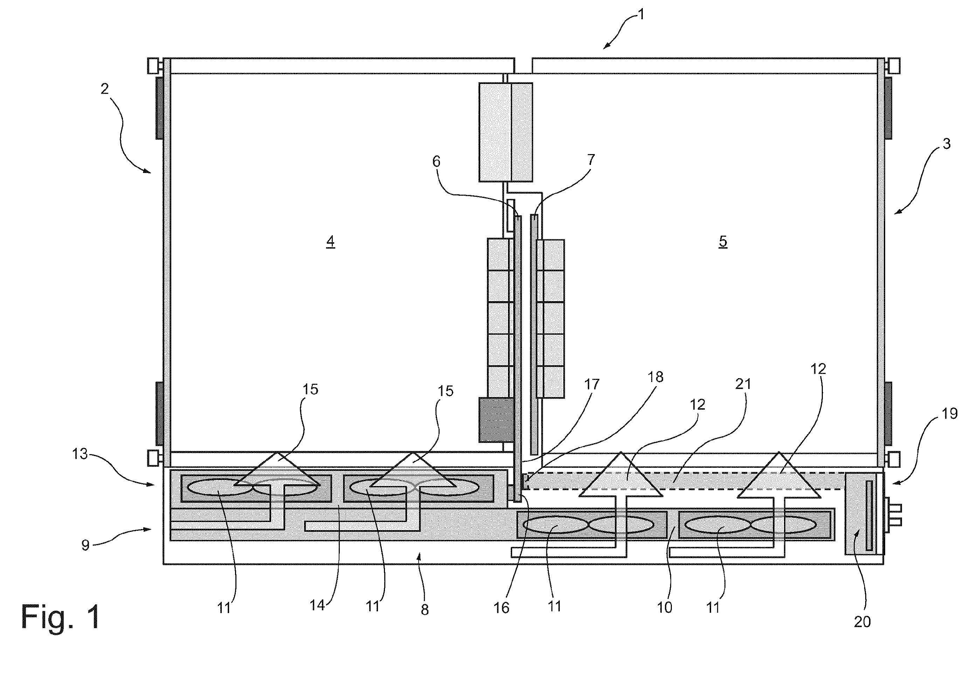

Figur 1 zeigt ein Gehäuse 1 mit einer Frontseite 2 und einer Rückseite 3, das zur Aufnahme von elektronischen Steckkarten dient. Das Gehäuse 1 umfasst einen frontseitigen Kartenkorb 4 und einen rückseitigen Kartenkorb 5. Zwischen dem frontseitigen Kartenkorb 4 und dem rückseitigen Kartenkorb 5 sind eine erste Backplane 6 und parallel zu dieser eine zweite Backplane 7 für den hinteren Kartenkorb 5 vertikal angeordnet.

Unterhalb der beiden Kartenkörbe 4, 5 ist ein Einbauraum 8 angeordnet. Der Einbauraum 8 erstreckt sich durchgehend von der Frontseite 2 des Gehäuses 1 bis in den Bereich des rückseitigen Kartenkorbs 5.

Der Einbauraum 8 weist eine erste untere Einbauebene 9 auf, in der ein erster Lüftereinschub 10 sitzt. Der erste Lüftereinschub 10 erstreckt sich in horizontaler Richtung bis in den Bereich des rückseitigen Kartenkorbs 5. Er umfasst Lüfter 11, die Luft im Bereich der Frontseite 2 des Gehäuses 1 ansaugen und entlang der Richtungspfeile 12 in Richtung des rückseitigen Kartenkorbs 5 fördern.

Der Einbauraum 8 umfasst weiter eine zweite obere Einbauebene 13, in der ein zweiter Lüftereinschub 14 angeordnet ist. Der zweite Lüftereinschub 14 ist kürzer und erstreckt sich nur bis zum Ende des frontseitigen Kartenkorbs 4; er weist Lüfter 11 auf. Mithilfe der Lüfter 11 des zweiten Lüftereinschubs 14 wird Luft von der Frontseite 2 des Gehäuses 1 angesaugt und entlang der Richtungspfeile 15 in Richtung des frontseitigen Kartenkorbs 4 gefördert.

Es versteht sich, dass die Lüfter des Lüftereinschubs 10 ebenso gut auch Luft ansaugen kann, die dann in umgekehrter Richtung, nämlich von den rückseitigen Steckkarten zum Lüftereinschub 10 strömt. Die erwärmte Kühlluft strömt dann aus den Kartenkörben 4, 5 in einen (nicht dargestellten) Abluftraum, der oberhalb der Kartenkörbe 4, 5 angeordnet ist. Auch eine Kombination von saugenden und drückenden Lüftern ist denkbar.

Es versteht sich auch, dass der erste Lüftereinschub 10 und der zweite Lüftereinschub 14 als ein Bauteil ausgebildet sein können, das frontseitig in das Gehäuse 1 eingeschoben wird. In dem Einbauraum 8 sind seitlich Führungen vorgesehen sein, auf denen die Lüftereinschübe 10, 14 gleiten.

In den Einbauraum 8 ragt die erste Backplane 6 mit ihrem unteren Ende 16 ein Stück weit hinein. Dadurch begrenzt die erste Backplane 6 die obere Einbauebene 13 in Richtung der Rückseite 3 des Gehäuses 1. Das untere Ende 16 der ersten Backplane 6 ist mit dem zweiten Lüftereinschub 14 mechanisch und elektrisch verbunden. Dadurch wird sowohl der Lüftereinschub 14 wie auch der Lüftereinschub 10 mit Strom versorgt.

Die Backplane 6 weist an ihrer Rückseite 17 im Bereich des unteren Endes 16 spezielle Steckverbinder 18 auf. Über diese Steckverbinder 18 ist die Backplane 6 mit einem Stromeinspeisemodul 19, das beide Backplanes 6, 7 mit Strom versorgt, verbunden.

Das Stromeinspeisemodul 19 umfasst eine kompakte Elektronikeinheit 20, die unterhalb des rückseitigen Kartenkorbs 5 im Bereich der Rückseite 3 des Gehäuses 1 angeordnet ist. Die Elektronikeinheit 20 begrenzt den Einbauraum 8 nach hinten, dass heißt in Richtung der Rückseite 3 des Gehäuses 1.

Die Elektronikeinheit 20 ist durch eine Anzahl starrer elektrischer Leiter 21 mit der Backplane 6 verbunden. Die elektrischen Leiter 21 verlaufen horizontal zwischen dem rückseitigen Kartenkorb 5 und dem ersten Lüftereinschub 10.

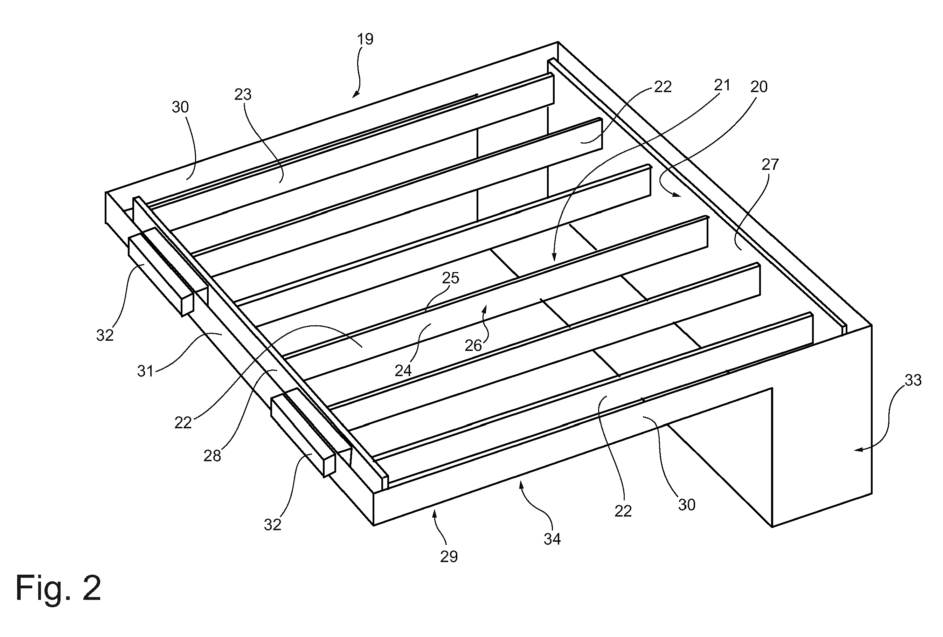

Gemäß Figur 2 sind die elektrischen Leiter 21 parallel und mit Abstand zueinander angeordnet. Die elektrischen Leiter 21 umfassen als Stromschienen 22 ausgebildete Stromleiter und zumindest einen Signalleiter 23. Die Stromschienen 22 weisen einen rechteckigen Querschnitt mit gegenüberliegenden langen Seiten 24 und kurzen Seiten 25 auf. Die langen Seiten 24 des rechteckigen Querschnitts verlaufen im Wesentlichen vertikal.

Die langen Seiten 24 der Stromschienen 22 bilden Luftleitflächen 26. Diese Luftleitflächen 26 leiten den Kühlluftstrom, der von den Lüftern 11 (Figur 1) erzeugt wird, in vertikaler Richtung zwischen den einzelnen Stromschienen 22 hindurch in Richtung des unmittelbar anschließenden rückseitigen Kartenkorbs 5 (Figur 1).

Die Stromschienen 22 verlaufen von einer ersten Leiterplatte 27, die Teil der Elektronikeinheit 20 ist, hin zu einer zweiten Leiterplatte 28. Sie sind von einem rechteckigen U-förmigen Rahmen 29 umgeben. Der U-förmige Rahmen 29 weist U-Schenkel 30 auf, die parallel zu den Stromschienen 22 verlaufen. Weiter umfasst der U-förmige Rahmen 29 einen U-Rücken 31, der die beiden U-Schenkel 30 miteinander verbindet und quer zu den U-Schenkeln angeordnet ist. Der U-Rücken 31 verläuft parallel zur ersten Backplane 6 (Figur 1). Im Bereich des U-Rückens 31 weist der U-förmige Rahmen 29 Steckverbinder 32 auf, mit denen eine Verbindung zwischen dem Stromeinspeisemodul 19 und der ersten Backplane 6 (Figur 1) hergestellt werden kann.

Das Stromeinspeisemodul 19 ist im Querschnitt L-förmig mit einem kurzen L-Schenkel 33 und einem langen L-Schenkel 34 ausgebildet. Die Elektronikeinheit 20 bildet den kurzen L-Schenkel 33, während die Stromschienen 22 den langen L-Schenkel 34 bilden.

### Bezugszeichenliste

- 1: Gehäuse
- 2: Frontseite
- 3: Rückseite
- 4: frontseitiger Kartenkorb
- 5: rückseitiger Kartenkorb
- 6: erste Backplane
- 7: zweite Backplane
- 8: Einbauraum
- 9: untere Einbauebene
- 10: erster Lüftereinschub
- 11: Lüfter
- 12: Richtungspfeile
- 13: obere Einbauebene
- 14: zweiter Lüftereinschub
- 15: Richtungspfeile
- 16: unteres Ende (Backplane)
- 17: Rückseite
- 18: Steckverbinder (Backplane)
- 19: Stromeinspeisemodul
- 20: Elektronikeinheit (Stromeinspeisemodul)
- 21: elektrische Leiter
- 22: Stromschiene
- 23: Signalleiter
- 24: lange Seite
- 25: kurze Seite
- 26: Luftleitfläche
- 27: erste Leiterplatte
- 28: zweite Leiterplatte
- 29: U-förmiger Rahmen
- 30: U-Schenkel
- 31: U-Rücken
- 32: Steckverbinder
- 33: kurzer L-Schenkel
- 34: langer L-Schenkel

## Patentansprüche

1. Gehäuse zur Aufnahme von elektronischen Steckkarten, beispielsweise eines Computersystems entsprechend der ATCA Extensions Norm mit einem frontseitigen Kartenkorb (4),
einem rückseitigen Kartenkorb (5),
zumindest einer vertikalen Backplane(6, 7), die zwischen dem frontseitigen Kartenkorb (4) und dem rückseitigen Kartenkorb (5) angeordnet ist,
einem unter oder über dem frontseitigen Kartenkorb (4) vorgesehenen Einbauraum (8), in den wenigstens ein Lüftereinschub (10) von der Frontseite (2) her horizontal einschiebbar ist,
einem Stromeinspeisemodul (19) mit einer Elektronikeinheit (20), welche die Backplane (6, 7) mit Strom versorgt,
**dadurch gekennzeichnet, dass**
sich der Einbauraum (8) für den Lüftereinschub (10) durchgehend bis in den Bereich des rückseitigen Kartenkorbs (5) erstreckt,
die Elektronikeinheit (20) des Stromeinspeisemoduls (19) unterhalb bzw. oberhalb des rückseitigen Kartenkorbs (5) im Bereich der Rückseite (3) des Gehäuses (1) angeordnet ist und den Einbauraum (8) nach hinten begrenzt,
die Elektronikeinheit (20) durch eine Anzahl starrer elektrischer Leiter (21) mit der Backplane (6) verbunden ist, wobei die Leiter (21) parallel und mit Abstand zueinander horizontal zwischen dem rückseitigen Klartenkorb (5) und dem Einbauraum (8) für den Lüftereinschub (10) verlaufen.

2. Gehäuse nach Anspruch 1, **dadurch gekennzeichnet, dass** die elektrischen Leiter (21) eine Anzahl von Stromschienen (22) umfassen, welche jeweils einen rechteckigen Querschnitt aufweisen, wobei die langen Seiten (24) des Querschnitts im Wesentlichen vertikal verlaufen.

3. Gehäuse nach Anspruch 2, **dadurch gekennzeichnet, dass** die langen Seiten (24) der Stromschienen (22) Luftleitflächen (26) für Kühlluft bilden.

4. Gehäuse nach Anspruch 2 oder 3, **dadurch gekennzeichnet, dass** das Stromeinspeisemodul (19) im Querschnitt L-förmig ausgebildet ist, wobei die Elektronikeinheit (20) den kurzen L-Schenkel (33) und die Stromschienen (22) den langen L-Schenkel (32) bildet.

5. Gehäuse nach Anspruch 4, **dadurch gekennzeichnet, dass** die Stromschienen (22) von einem rechteckigen U-förmigen Rahmen (29) umgeben sind, wobei die U-Schenkel (30) parallel zu den Stromschienen (22) verlaufen und der U-Rücken (31) dazu quer und parallel zur Backplane (6, 7) angeordnet ist.

6. Gehäuse nach Anspruch 5, **dadurch gekennzeichnet, dass** der den U-Rücken (31) bildende Abschnitt des Rahmens (29) Steckverbinder (32) zur Herstellung der Verbindung mit der Backplane (6) trägt.

7. Gehäuse nach einem der vorhergehenden Ansprüche, **dadurch gekennzeichnet, dass** der Einbauraum (8) zwei Einbauebenen (9, 13) übereinander aufweist, wobei die erste Einbauebene (9) einen ersten Lüftereinschub (10) aufnehmen kann, welcher sich bis in den Bereich des rückseitigen Kartenkorbs (5) erstreckt, und die zweite Einbauebene (13) einen zweiten Lüftereinschub (14) aufnehmen kann, welcher sich nur bis zum Ende des frontseitigen Kartenkorbs (4) erstreckt.

8. Gehäuse nach Anspruch 7, **dadurch gekennzeichnet, dass** die Backplane (6) mit ihrem einen Ende (16) in den Einbauraum (8) hineinragt und dadurch die zweite Einbauebene (13) nach hinten begrenzt.

9. Gehäuse nach Anspruch 8, **dadurch gekennzeichnet, dass** die Backplane (6) an ihrer Rückseite (17) im Bereich ihres in den Einbauraum (8) hineinragenden Endes (16) Steckverbinder (18) zum Anschluss des Stromeinspeisemoduls (19) trägt.

10. Stromeinspeisemodul zur Verwendung als das Stromeinspeisemodul eines Gehäuses (1) nach einem der vorhergehenden Ansprüche, umfassend:
eine Elektronikeinheit (20) zur Erzeugung der Versorgungsspannungen für die Backplane (6, 7),
elektrische Leiter (21), welche die Elektronikeinheit (20) mit der Backplane (6) verbinden,
wobei die elektrischen Leiter (21) Stromschienen (22) umfassen, die einen rechteckigen Querschnitt mit jeweils gegenüberliegenden langen Seiten (24) und kurzen Seiten (25) aufweisen,
wobei die Stromschienen (22) entlang der langen Seiten (24) im Wesentlichen parallel zueinander und voneinander beabstandet angeordnet sind und,
**dadurch gekennzeichnet, dass**
das Stromeinspeisemodul (19) im Querschnitt L-förmig ausgebildet ist, wobei die Elektronikeinheit (20) den kurzen L-Schenkel (33) und die Stromschienen (22) den langen L-Schenkel (34) bildet, und
die langen Seiten (24) des rechteckigen Querschnitts der Stromschienen (22) im eingebauten Zustand des Stromeinspeisemoduls (19) im Wesentlichen vertikal verlaufen und Luftleitflächen (26) für Kühlluft bilden.

11. Stromeinspeisemodul nach Anspruch 10, **dadurch gekennzeichnet, dass** die Stromschienen (22) von einem U-förmigen Rahmen (29) umgeben sind, wobei die U-Schenkel (30) parallel zu den Stromschienen (22) verlaufen und der U-Rücken (31) dazu quer angeordnet ist.

12. Stromeinspeisemodul nach Anspruch 11, **dadurch gekennzeichnet, dass** der den U-Rücken (31) bildende Abschnitt des Rahmens (29) Steckverbinder (32) zur Herstellung der Verbindung mit einer Backplane (6) trägt.

## Claims

1. Rack for accommodating electronic plug-in boards, for example, of a computer system according to the ATCA Extensions standard, with a board cage (4) on the front side,
a board cage (5) on the rear side,
at least one vertical backplane (6, 7) that is arranged between the board cage (4) on the front side and the board cage (5) on the rear side,
an installation space (8) that is provided underneath or above the board cage (4) on the front side and into which at least one fan module (10) can be horizontally inserted from the front side (2), and
a power supply module (19) with an electronics unit (20) that supplies the backplane (6, 7) with power,
**characterized in that**
the installation space (8) for the fan module (10) continuously extends up to the region of the board cage (5) on the rear side,
the electronics unit (20) of the power supply module (19) is arranged in the region of the rear side (3) of the rack (1) underneath or above the board cage (5) on the rear side and defines the installation space (8) toward the rear, and
the electronics unit (20) is connected to the backplane (6) by a number of rigid electric conductors (21), wherein the conductors (21) horizontally extend between the board cage (5) on the rear side and the installation space (8) for the fan module (10) parallel and at a distance from one another.

2. Rack according to Claim 1, **characterized in that** the electric conductors (21) comprise a number of busbars (22) that respectively have a rectangular cross section, wherein the long sides (24) of the cross section essentially extend vertically.

3. Rack according to Claim 2, **characterized in that** the long sides (24) of the busbars (22) form air baffles (26) for cooling air.

4. Rack according to Claim 2 or 3, **characterized in that** the power supply module (19) is realized with an L-shaped cross section, wherein the electronics unit (20) forms the short L-limb (33) and the busbars (22) form the long L-limb (32).

5. Rack according to Claim 4, **characterized in that** the busbars (22) are surrounded by a rectangular U-shaped chassis (29), wherein the U-limbs (30) extend parallel to the busbars (22) and the U-crosspiece (31) is arranged transverse thereto and parallel to the backplane (6, 7).

6. Rack according to Claim 5, **characterized in that** the section of the chassis (29) that forms the U-crosspiece (31) carries plug-type connectors (32) for producing the connection with the backplane (6).

7. Rack according to any one of the preceding claims, **characterized in that** the installation space (8) has two installation levels (9, 13) that lie on top of one another, wherein the first installation level (9) can accommodate a first fan module (10) that extends up to the region of the board cage (5) on the rear side and the second installation level (13) can accommodate a second fan module (14) that only extends up to the end of the board cage (4) on the front side.

8. Rack according to Claim 7, **characterized in that** the backplane (6) protrudes into the installation space (8) with one end (16) and thusly defines the second installation level (13) toward the rear.

9. Rack according to Claim 8, **characterized in that** the backplane (6) carries on its rear side (17) plug-type connectors for connecting the power supply module (19) in the region of its end (16) that protrudes into the installation space (8).

10. Power supply module for use as the power supply module of a rack (1) according to any one of the preceding claims, comprising:
an electronics unit (20) for generating the supply voltages for the backplane (6, 7),
electric conductors (21) that connect the electronics unit (20) to the backplane (6),
wherein the electric conductors (21) comprise busbars (22) that have a rectangular cross section with respectively opposing long sides (24) and short sides (25),
wherein the busbars (22) are essentially arranged parallel to one another and spaced apart from one another along the long sides (24),
**characterized in that**
the power supply module (19) has L-shaped cross section, wherein the electronics unit (20) forms the short L-limb (32) and the busbars (22) form the long L-limb (34), and
the long sides (24) of the rectangular cross section of the busbars (22) essentially extend vertically in the built-in situation and form air baffles (26) for cooling air,

11. The power supply module according to Claim 10, **characterized in that** the busbars (22) are surrounded by a U-shaped chassis (29), wherein the U-limbs (30) extend parallel to the busbars (22) and the U-crosspiece (31) is arranged transverse thereto.

12. The power supply module according to Claim 11, **characterized in that** the section of the chassis (29) that forms the U-crosspiece (31) carries plug-type connectors (32) for producing the connection with a backplane (6).

## Revendications

1. Boîtier destiné à la réception de cartes enfichables électroniques, par exemple d'un système informatique correspondant à la spécification d'extensions ATCA avec
un panier à cartes avant (4),
un panier à cartes arrière (5),
au moins un fond de panier vertical (6, 7), qui est disposé entre le panier à cartes avant (4) et le panier à cartes arrière (5),
une chambre de montage (8) prévue en dessous ou au-dessus du panier à cartes avant (4), dans laquelle au moins un tiroir à ventilateur (10) peut être introduit horizontalement à partir du côté avant (2),
un module d'alimentation électrique (19) avec une unité électronique (20), qui alimente le fond de panier (6, 7) en courant,
**caractérisé en ce que**
la chambre de montage (8) pour le tiroir à ventilateur (10) s'étend de façon continue jusque dans la région du panier à cartes arrière (5),
l'unité électronique (20) du module d'alimentation électrique (19) est disposée en dessous ou au-dessus du panier à cartes arrière (5) dans la région de la face arrière (3) du boîtier (1) et limite vers l'arrière la chambre de montage (8), l'unité électronique (20) est reliée au fond de panier (6) par plusieurs conducteurs électriques rigides (21), dans lequel les conducteurs (21) s'étendent parallèlement et à distance l'un de l'autre horizontalement entre le panier à cartes arrière (5) et la chambre de montage (8) pour le tiroir à ventilateur (10).

2. Boîtier selon la revendication 1, **caractérisé en ce que** les conducteurs électriques (21) comprennent une pluralité de barres conductrices (22), qui présentent respectivement une section transversale rectangulaire, dans lequel les longs côtés (24) de la section transversale sont essentiellement verticaux.

3. Boîtier selon la revendication 2, **caractérisé en ce que** les longs côtés (24) des barres conductrices (22) forment des faces de guidage d'air (26) pour l'air de refroidissement.

4. Boîtier selon la revendication 2 ou 3, **caractérisé en ce que** le module d'alimentation électrique (19) est réalisé avec une section transversale en forme de L, dans lequel l'unité électronique (20) forme la courte branche du L (33) et les barres conductrices (22) forment la longue branche du L (32).

5. Boîtier selon la revendication 4, **caractérisé en ce que** les barres conductrices (22) sont entourées par un cadre en U rectangulaire (29), dans lequel les branches du U (30) sont parallèles aux barres conductrices (22) et l'arrière du U (31) est disposé transversalement à celles-ci et parallèlement au fond de panier (6, 7).

6. Boîtier selon la revendication 5, **caractérisé en ce que** la partie du cadre (29) formant l'arrière du U (31) porte des connecteurs enfichables (32) permettant de réaliser la liaison avec le fond de panier (6).

7. Boîtier selon l'une quelconque des revendications précédentes, **caractérisé en ce que** la chambre de montage (8) présente deux plans de montage l'un au-dessus de l'autre (9, 13), dans lequel le premier plan de montage (9) peut recevoir un premier tiroir à ventilateur (10), qui s'étend jusque dans la région du panier à cartes arrière (5), et le deuxième plan de montage (13) peut recevoir un deuxième tiroir à ventilateur (14), qui ne s'étend que jusqu'à la fin du panier à cartes avant (4).

8. Boîtier selon la revendication 7, **caractérisé en ce que** le fond de panier (6) pénètre avec sa première extrémité (16) dans la chambre de montage (8) et limite ainsi le deuxième plan de montage (13) vers l'arrière.

9. Boîtier selon la revendication 8, **caractérisé en ce que** le fond de panier (6) porte sur son côté arrière (17), dans la région de son extrémité (16) pénétrant dans la chambre de montage (8), des connecteurs enfichables (18) permettant de raccorder le module d'alimentation électrique (19).

10. Module d'alimentation électrique destiné à une utilisation comme le module d'alimentation électrique d'un boîtier (1) selon l'une quelconque des revendications précédentes, comprenant:
une unité électronique (20) pour la production de tensions d'alimentation pour le fond de panier (6, 7),
des conducteurs électriques (21), qui relient l'unité électronique (20) au fond de panier (6),
dans lequel les conducteurs électriques (21) comprennent des barres conductrices (22), qui présentent une section transversale rectangulaire avec des longs côtés (24) et cotés courts (25) respectivement opposés,
dans lequel les barres conductrices (22) sont disposées essentiellement parallèlement l'une à l'autre le long des longs côtés (24) et à distance l'une de l'autre, et
**caractérisé en ce que**
le module d'alimentation électrique (19) est réalisé avec une section transversale en forme de L, dans lequel l'unité électronique (20) forme la courte branche du L (33) et les barres conductrices (22) forment la longue branche du L (34), et
les longs côtés (24) de la section transversale rectangulaire des barres conductrices (22) sont essentiellement verticaux dans l'état monté du module d'alimentation électrique (19) et forment des faces de guidage d'air (26) pour l'air de refroidissement.

11. Module d'alimentation électrique selon la revendication 10, **caractérisé en ce que** les barres conductrices (22) sont entourées par un cadre en forme de U (29), dans lequel les branches du U (30) s'étendent parallèlement aux barres conductrices (22) et l'arrière du U (31) est disposé transversalement à celles-ci.

12. Module d'alimentation électrique selon la revendication 11, **caractérisé en ce que** la partie du cadre (29) formant l'arrière du U (31) porte des connecteurs enfichables (32) permettant de réaliser la liaison avec le fond de panier (6).
